# EUROPEAN PATENT APPLICATION

(11) **EP 4 079 879 A1**
(43) Date of publication of application: **26.10.2022**
(21) Application number: 21169384.1
(22) Date of filing: 20.04.2021
(51) Int. Cl.: C22C 19/07, C23C 14/34, C22F 1/10

(54) **COZRTA(X) SPUTTERING TARGET WITH IMPROVED MAGNETIC PROPERTIES**

(71) Applicant: Materion Advanced Materials Germany GmbH, 63755 Alzenau (DE)
(72) Inventor: KONIETZKA, Uwe, 63826 Geiselbach (DE); SCHLOTT, Martin, 63075 Offenbach (DE)
(74) Representative: Kador & Partner PartG mbB

(57) **Abstract**

The present invention relates to a sputtering target comprising an alloy of Co, Zr, Ta and, optionally, one or more further element(s) X from the group of Mo, Pd, Ni, Ti, V, W, and B, wherein the target has a maximum pass through flux (PTF) variation (F_{Max}-F_{Min})/F_{Average} of 0.2 or lower, preferably of 0.15 or lower, and most preferably of 0.10 or lower.

## Description

The present invention relates to a target for sputtering with a magnetron cathode, the target being based on a Co alloy with additives including Zr, Ta and, optionally, at least one of the elements Pt, Pd, Ni, Ti, V, W, and B.

In the process of magnetron cathode sputtering, permanent magnets are installed behind the target (the cathode) to optimize the sputtering process. These magnets are arranged in such a way that a magnetic field forms in front of the target, i.e., in the discharge space. This magnetic field has the effect of localizing the discharge plasma. The area of the target surface over which the plasma is localized is subjected to more active sputtering, as a result of which an erosion groove (or race track) is formed there.

In the case of ferromagnetic targets, such as CoZrTa(X) alloys, there are two main problems which occur in this situation:
First, the magnetic flux of the permanent magnets is focused within the target, so that only a small amount of flux can penetrate into the discharge space. This problem therefore requires the use of very thin ferromagnetic targets - or extremely strong magnet sets.

Second, the local reduction in the cross section of the target (erosion groove) which occurs when cathodic sputtering is carried out with ferromagnetic targets has the effect of increasing the magnetic flux directly above the erosion groove. As a result, there is a local increase in ionization of the sputtering gas and also a local increase in the sputtering rate. The erosion groove therefore becomes increasingly narrow, as the sputtering progresses, and this is associated with a very low rate of target material utilization.

Furthermore, the variation of the magnetic pass through flux measured at different points of the targets should be as low as possible, so that target material utilization is as homogenous and the thickness of the deposited film is as uniform as possible.

Improved magnetic field geometries and higher magnetic field penetration can be achieved by means of complicated target designs. The magnetic resistance in the target can be increased and a larger field produced in the discharge space by providing the target with slots perpendicular to the direction of the magnetic field (K. Nakamura et al.: IEEE Transactions on Magnetics, Vol. MAG-18, pp. 1,080-1,082, 1982).

Kukla et al. (IEEE Transactions on Magnetics, Vol. MAG-23, pp. 137-139, 1987) describe a cathode for ferromagnetic materials, which consists of several individual targets, arranged in two planes one above the other, in order to obtain a stronger magnetic field. These designs are more expensive, however, and make the operation of magnetron cathode sputtering more difficult.

It is the object of the present invention to provide a target based on an CoZrTa(X) alloy which has improved magnetic homogeneity, i.e. which shows a reduced variation of the magnetic pass through flux at different points of the target, for use for magnetron cathode sputtering.

The present invention is based on the finding that such a sputtering target can be provided if the CoZrTa(X) alloy is thermally treated at high temperature so that the magnetic permeability of the alloy is reduced and also the variation of the magnetic flux is reduced.

Accordingly, the present invention relates to a sputtering target comprising, or consisting of, an alloy comprising, or consisting of, Co, Zr, Ta and optionally one or more further element X from the group of Mo, Pd, Ni, Ti, V, W, and B, wherein the target has a maximum pass through flux (PTF) variation (F_{Max}-F_{Min})/F_{Average} of 0.2 or lower, wherein
F_{Max} is the maximum magnetic flux density measured at a measuring point on the target,
F_{Min} is the minimum magnetic flux density measured at a measuring point on the target,
F_{Average} is the average magnetic flux density, i.e. the sum of the measured magnetic flux densities at all measuring points divided by the number of measuring points,
and wherein the measurement is carried out at 7 equally spaced different measurement points of a target as described herein below.

The target of the invention shows a low variation of the magnetic flux at different points of the target and hence solves the objects as described above.

Preferably, the target has a maximum pass through flux (PTF) variation (F_{Max}-F_{Min})/F_{Average} of 0.15 or lower, more preferably of 0.10 or lower.

Preferably, the total amount in at.% of element(s) X is smaller than the larger one of the two additions of Ta or Zr in at.%.

The sputtering target of the invention has a reduced magnetic permeability and hence allows for an increased magnetic flux through the target, so that the above described main problems in magnetron sputtering can be avoided or at least alleviated.

Targets of the invention can be manufactured to an increased thickness which provides a longer target lifetime at the user, better film uniformity and a more constant sputtering rate over target life.

Zr is preferably present in the alloy in an amount of from 2 to 8 at.%, more preferably from 3 to 7 at.%.

Ta is preferably present in the alloy in an amount of from 2 to 8 at.%, more preferably from 3 to 7 at.%.

If in the alloy one or more further optional element X from the group of Mo, Pd, Ni, Ti, V, W, and B is present, this is preferably in a total amount of element(s) X of up to 7 at.%, more preferably of up to 3 at.%.

Preferably, if a further element X from the group of Mo, Pd, Ni, Ti, V, W, and B is present in the alloy it is only one of these elements.

Preferably, in the sputtering target of the invention Co is present in the CoZrTa(X) alloy in an amount of at least 75 at.%, more preferably at least 90 at.%.

Preferably, the CoZrTa(X) alloy consists of Zr, Ta, optionally one or more further element X from the group of Mo, Pd, Ni, Ti, V, W, and B, and Co, i.e. Co makes up the remainder of the atoms in the alloy.

The sputtering target of the invention preferably has a maximum magnetic permeability µₘₐₓ of 60, more preferably of 50 or lower, and still more preferably of 40 or lower.

The maximum magnetic permeability µₘₐₓ is usually not less than 10 or 20.

Further preferred, the sputtering target of the invention has a saturation magnetization Js, measured as Js=J(H=60kA/m) of 0.8 T or below.

The saturation magnetization Js is usually not less than 0.5 T.

Preferably, the magnetic pass through flux (PTF) measured according to ATSM F2086-01 of the target is 20 % or higher, more preferably is 25 % or higher.

The invention further relates to a process for producing a sputtering target material comprising an alloy of Co, Zr, Ta and, optionally, one further element X from the group of Mo, Pd, Ni, Ti, V, W, and B, wherein the process involves heating the alloy to a temperature of at least 700 °C, more preferably to at least 750 °C and still more preferably at least 800 °C.

Preferably, heating is performed to a temperature of at most 1000°C, more preferably at most 900 °C.

Usually, heating is done by introducing the alloy into an oven pre-heated to the desired temperature.

Heating of the alloy to the temperature as prescribed above is preferably performed for a time of 10 to 60 hours, more preferably 12-48 hours.

Furthermore, the invention relates to a magnetron sputtering process in which a sputtering target in any one of the embodiments described herein is used, to a layer produced by said sputtering process, and to the use of a sputtering target in any one of the embodiments described herein for magnetron sputtering.

### Definitions/Measurement methods

### a) Measurement of Magnetic Properties

Pass Through Flux (PTF) was measured according to ASTM F2086-01 method 2.

In order to determine the variation of the pass through flux on the targets of the invention, PTF was measured according to ASTM F2086-01 method 2 by placing the 4 mm thick finish machined target plates of 650x130mm, 4mm+-0.1 thickness on the PTF measurement stand. The measurements were performed at 7 different equally spaced positions along the length of the targets. Accordingly, all measurement point were at the middle position (65 mm) along the breadth (130 mm) of the target, and were at the following positions along the length (650 mm) of the target, seen from the left end (0 mm):
Point 1: 50 mm
Point 2: 142 mm
Point 3: 234 mm
Point 4: 325 mm
Point 5: 415 mm
Point 6: 508 mm
Point 7: 600 mm.

Measurement of the magnetic flux density without a target yielded 420 Gauss = 100% PTF reference value.

Magnetization curves to determine the magnetic permeability µₘₐₓ was measured using Remagraph C of Magnet-Physik in accordance with DIN EN 60404-4.

### Examples

Four CoZrTa alloy samples with a composition of 91.5 at.% Co, 4 at.% Zr and 4.5 at% Ta each were produced by conventional vacuum induction melting and casting, followed by hot rolling at 1200°C to obtain four plates with dimensions 653 x 133 x 8 mm.

The plates were then subjected to a heat treatment at 860°C for 26h followed by air cooling.

The PTF of the plates after heat treatment was 30.2 %.

Measurement of the magnetization curve of the plates yielded a maximum permeability of ∼30 at magnetic fields of 15kA/m and a saturation magnetization of 721 mT.

Targets A, B C and D with dimensions of 650 x 130 x 4 mm were machined from the four CoZrTa alloy plates.

The results of the PTF measurements at the various positions of the targets are given in Table 1:

**Table 1:**

| | Target A | | Target B | | Target C | | Target D | |
|---|---|---|---|---|---|---|---|---|
| Measureme nt point | Flux Densit y/Gau ss | PTF % | Flux Densit y/Gau ss | PTF % | Flux Densit y/Gau ss | PTF % | Flux Densit y/Gau ss | PTF % |
| 1 | 193.8 | 46.14% | 199.5 | 47.50% | 198.9 | 47.36% | 199.3 | 47.45% |
| 2 | 188.1 | 44.79% | 191.6 | 45.62% | 191.3 | 45.55% | 187.5 | 44.64% |
| 3 | 191.3 | 45.55% | 191.4 | 45.57% | 193.5 | 46.07% | 187.2 | 44.57% |
| 4 | 186.5 | 44.40% | 192.3 | 45.79% | 194.2 | 46.24% | 190.0 | 45.24% |
| 5 | 183.0 | 43.57% | 185.0 | 44.05% | 188.6 | 44.90% | 187.1 | 44.55% |
| 6 | 184.3 | 43.88% | 186.0 | 44.29% | 190.0 | 45.24% | 188.0 | 44.76% |
| 7 | 195.0 | 46.43% | 196.9 | 46.88% | 199.6 | 47.52% | 197.0 | 46.90% |
| | | | | | | | | |
| Average Flux Density | 188.8 | 44.97% | 191.8 | 45.67% | 193.7 | 46.13% | 190.9 | 45.45% |
| F_{Max}-F_{Min} | 12 | 2.86% | 14.5 | 3.45% | | 2.62% | | 2.90% |
| (F_{Max}-F_{Min})/F_{Average} | 0.064 | | 0.076 | | 0.057 | | 0.064 | |

As can be seen from Table 1 the tested targets showed a low variation of the PTF throughout the targets, as expressed by the low values for (F_{Max}-F_{Min})/F_{Average}.

## Claims

1. Sputtering target comprising an alloy of Co, Zr, Ta and, optionally, one or more further element(s) X from the group of Mo, Pd, Ni, Ti, V, W, and B, wherein the target has a maximum pass through flux (PTF) variation (F_{Max}-F_{Min})/F_{Average} of 0.2 or lower, preferably of 0.15 or lower, and most preferably of 0.10 or lower.

2. Sputtering target according to claim 1 wherein Ta is present in the alloy in an amount of from 2 to 8 at.%.

3. Sputtering target according to claim 1 or 2 wherein Zr is present in an amount of from 2 to 8 at.%.

4. Sputtering target according to any one of the preceding claims wherein one or more further element(s) X from the group of Mo, Pd, Ni, Ti, V, W, and B are present in the alloy in a total amount of up to 7 at.%.

5. Sputtering target according to any one of the preceding claims wherein the alloy consists of Co, Zr, Ta and, optionally, one or more further element(s) X from the group of Mo, Pd, Ni, Ti, V, W, and B.

6. Sputtering target according to any one of the preceding claims wherein the target has a maximum magnetic permeability µₘₐₓ of 60 or lower, preferably of 50 or lower, and more preferably of 40 or lower.

7. Sputtering target according to any one of the preceding claims wherein the a 8 mm target plate has a magnetic pass of at least 20%.

8. Process for producing a sputtering target comprising an alloy of Co, Zr, Ta and, optionally, one or more further element(s) X from the group of Mo, Pd, Ni, Ti, V, W, and B, wherein the process involves heating the alloy to a temperature in the range of 700 to 1000°C, preferably of 800 to 900°C.

9. Process according to claim 9 wherein the alloy is heated for a time of 10 to 60 hours, preferably 12-48 hours.

10. Magnetron sputtering process in which a sputtering target according to any one of claims 1 to 7 is used.

11. Layer produced by a sputtering process according to claim 10.

12. Use of a sputtering target according to any one of claims 1 to 7 for magnetron sputtering.
